Europäisches Patentamt

European Patent Office

Office européen des brevets

(11) Publication number: **0 211 958**
**A1**

# EUROPEAN PATENT APPLICATION

published in accordance with Art. 158(3) EPC

(21) Application number: **86901127.0**

(22) Date of filing: **31.01.86**

Data of the international application taken as a basis:

(86) International application number: **PCT/JP 86/00040**

(87) International publication number: **WO 86/04739 (14.08.86 86/18)**

(51) Int. Cl.⁴: **H 01 P 1/38, H 01 P 1/36, H 01 P 1/32**

(30) Priority: **06.02.85 JP 19921/85**

(43) Date of publication of application: **04.03.87 Bulletin 87/10**

(84) Designated Contracting States: **DE FR GB**

(71) Applicant: **HITACHI, LTD., 6, Kanda Surugadai 4-chome Chiyoda-ku, Tokyo 100 (JP)**

(72) Inventor: **KINOSHITA, Yasuaki, 2-34-2, Sanda-cho, Hachioji-shi Tokyo 193 (JP)**
Inventor: **OHKAWA, Sumio, 2-2-2, Hatagaya, Shibuya-ku Tokyo 151 (JP)**

(74) Representative: **Altenburg, Udo, Dipl.-Phys. et al, Patent- und Rechtsanwälte Bardehle-Pagenberg-Dost-Altenburg-Frohwitter & Partner Postfach 86 06 20, D-8000 München 86 (DE)**

(54) **MAGNETOSTATIC WAVE CIRCULATOR.**

(57) In order to miniaturize a circulator, which is used in a VHF band, by utilizing a photoetching method, a chip, which is obtained by forming a membrane of yttrium iron garnet (YIG) monocrystals on a substrate of gadolinium garnet monocrystals, is placed on a microstrip board (9) (a square portion shown by a broken line), and a magnetostatic field is applied to a concentric strip type portion (a circular portion shown by a broken line) in the YIG membrane in the centrifugal (or centripetal) direction. Three transducers (11), which are connected to a magnetostatic wave flowing in the direction of arrows, are arranged so as to be spaced from one another at 120° in the centrifugal (or centripetal) direction on the portions of the microstrip board (9) which correspond to the concentric strip type portion. Each transducer is connected at one end thereof to a strip conductor (10), and at the other end thereof to a conductor on the lower surface of the board (9) via a through hole.

DESCRIPTION

TITLE OF THE INVENTION

MAGNETOSTATIC WAVE CIRCULATOR

TECHNICAL FIELD

The present invention relates to a magnetostatic wave circulator and, more particularly, to a circulator which operates in an ultra-high frequency (i.e.,UHF) region such as from 500 MHz upto 20 GHz and in which signals are circularly and cyclically coupled among plurality of input/output terminals so that it provides a UHF nonreciprocal device suitable for circuit integration because it makes use of a magnetostatic surface wave mode.

BACKGROUND ART

Most of the modern components for a high frequency signal processing circuit in the UHF region are constructed of microwave integrated circuits (i.e., MIC) technology. It is important to reduce the size of the circulator because the circulator occupies a relatively large size in the microwave integrated circuit of that kind according to the prior art.

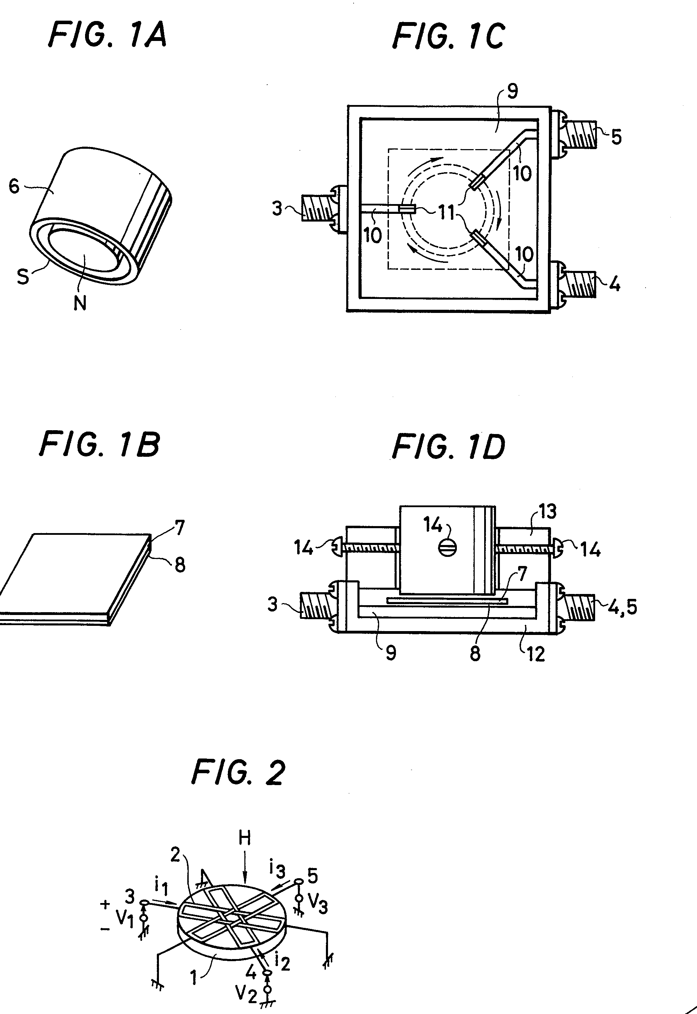

In a small-sized circulator having the structure of the rpior art, as shown in Fig. 2, a plurality of conducting loops crossed over one another are mounted on one face of a flattened cylindrical ferrite

- 2 -

0211958

disk (as is disclosed in J. Appl. Phys., Vol. 55, No. 6, 15, March 1984).

Since the circulator has its thin conductors overlapped complexly, it is difficult for the circulator to fablicate by the photolighographic technology so that it is not suited for mass production.

As a circulator using none of the aforementioned complex conductors, on the other hand, there is known a junction type microstripe line circulator which is constructed by arranging simple conductor electrodes on one surface of the cylindrical ferrite. However, this circulator uses the radial resonance of the ferrite disk and requires a disk diameter inversely proportional to the frequency used so that it cannot reduce the size of the ferrite to raise a problem that the circulator is large-sized and cannot have its size reduced.

DISCLOSURE OF INVENTION

Therefore, the present invention contemplates to realize a circulator for high frequency signal processing circuits, which has a remarkably simple and small structure so that it can be fabricated by making use of the photolithographic technology.

In order to achieve the above-specified object, according to the present invention, a circulator is constructed by arranging a plurality of micro conducting strips in radial directions, i.e., centrifugally or centripetally on a film made of a material capable of magnetostatic wave propagation, by providing means to apply on said film a bias magnetic field· parallel to said each plural conducting strips, and by attaching a bonding pad electrode to one end of each of said conducting micro strips.

According to a preferred mode of the present invention, the circulator is constructed by forming an epitaxial film of yttrium iron garnet (i.e., YIG) on a gadolinium gallium garnet (i.e., GGG) substrate by applying a bias magnetic field in the radial direction to a circular belt portion on said film, and by connecting a dielectric substrate, and microstrip lines formed of conducting strips and a conducting plane on the back of said dielectric substrate with the both ends cf transducers having several stripes juxtaposed in the radial direction (i.e., centrifugally or centripetally) on the surface of said circular belt portion.

BRIEF DESCRIPTION OF DRAWING

Fig. 1A is a perspective view showing magnetic field generating means to be used in one embodiment of the present invention;

Fig. 1B is a perspective view showing a substrate to be used in the embodiment of the present invention;

Figs. 1C and 1D are a top plan view and a side elevation showing the embodiment of the circulator according to the present invention, respectively; and

Fig. 2 is a perspective view showing the circulator of the prior art.

. BEST MODE FOR CARRYING OUT THE INVENTION

Figs. 1C and 1D are a top plan view and a side elevation showing the embodiment of the circulator according to the present invention, respectively.

· As shown in Fig. 1B, a chip is constructed by forming a yttrium iron garnet (YIG) epitaxial film 8 on a gadlinium gallium garnet (GGG) substrate. The chip thus constructed is arranged in such a position on a microstrip substrate 9 in a conductor package 12 as is indicated by broken lines (in a square) in Fig. 1C. As shown in perspective view in Fig. 1A, moreover, there is arranged on that chip a cylindrical permanent magnet 6 which is composed of N and S magnetic poles in a concentric form, such that the gap between the N and S poles is defined by the circular belt of dashed lines in Fig. 1C. That magnet 6 is so fixed that its position can be adjusted by means of a holder 13 and screws 14.

Over the microstrip substrate 9, there are arranged through three microstrip lines 10 three transducers 11 for exciting the magnetostatic surface waves such that they are arranged in centrifugal (or centripetal) directions at an angular spacing of 120 degrees and aligned with the gap between the aforementioned N and S poles. The respective one-side ends of the three microstrip lines 10 are connected with coaxial connectors 3, 4 and 5 which are attached to the package 12.

In the structure thus far described, the magnetic field of the permanent magnet 6 is generated in the centrifugal directions in the ring-shaped portion of the YIG film indicated by the broken lines so that the portions exposed to the magnetic field provide a magnetostatic surface waveguide of circular belt shape.

If an electric high frequency field is applied to the micristrip transducers, the magnetostatic surface waves are excited to intersect the direction of the bias magnetic field at right angles and propagate on the side of the aforementioned YIG film contacting with the aforementioned strip line plane and travel toward clockwise direction through the wauegude portion indicated by the circular broken lines in Fig. 1C. On the other hand, the surface waves excited in the interface between the YIG thin film and the GGG substrate propagate in the direction opposite to that of the foregoing surface waves. With this in mind, the electrode shapes of the transducers 11, the thickness of the YIG film and the bias magnetic field are designed to ensure a sufficient coupling intensity to the magnetostatic surface waves toward the clockwise direction (surface waves on the side of YIG film surface) but to reduce the coupling to the surface waves in the counter-clockwise direction (surface waves between the YIG film and the GGG substrate).

Each of the transducers is constructed by having the structure in which its one end is connected to the aforementioned microstrip lines and its other end is connected through a via-hole with the back conductor of the microstrip substrate 9, and the aforementioned one or more transducer electrode are arranged in the centrifugal (or centripetal) directions on the aforementioned circular strip waveguide (as indicated by the broken lines in Fig. 1C).

According to the structure thus far described, the signals applied to the coaxial connectors 3, 4 and 5 are output to the coaxial connections of the connectors 5, 3 and 4, respectively, to construct the circulator.

The foregoing description has been made upon the embodiment of the three-electrode circulator which is used most widely, but the present invention can likewise realize a circulator having more electrodes.

INDUSTRIAL APPLICABILITY

The present invention can be applied to the circular to be used as a circuit for processing signals in a frequency band of 500 MHz to 50 GHz, especially in the UHF band.

The fact that the circulator making use of the magnetostatic field according to the present invention is far more easily fabricated than the circulator having the crossed and isolated loop electrodes shown in Fig. 2 is apparent in view of the fact that the electrodes (or transducers) can be remarkably easily realized by the photolithography. Moreover, the YIG film chip of the circulator of the present invention can be more easily fabricated than the prior art using the ferrite disk because it makes use of the fabrication technology of the semiconductor integrated element.

Still moreover, the permanent magnet has an internal magnetic field of 30 to 60 Öe in the band of 1 GHz in the direction of the plane of the YIG film although that of the prior art has an internal magnetic field of 1000 to 2,000 Öe only tward the direction of the thickness of the ferrite. Considering the self-demagnetization effect of the YIG film, it is apparent that the magnets to be used in the present invention can be far more small-sized.

CLAIMS

1.   A magnetostatic circulator comprising:

a chip having a film material for generating magnetostatic waves when it is given a bias magnetic field and high frequency electric signals;

a magnetic field generating means for propagating a magnetostatic wave in a concentric strip shape portion and tward a centrifugal (or centripetal) direction  to said film;

at least three transducers arranged in the vicinity of or on the surface portion of said concentric strip shape (each of said transducers being constructed to have one or more strip electrodes juxtaposed in a centrifugal (or centripetal) direction in said concentric strip shape portion); and

a dielectric substrate having a conductive plane on its back (said dielectric substrate being provided on its surface with a plurality of conducting strips, with which are connected the respective one-side ends of said transducers having their other ends connected with the conducting plane on the back of said dielectric substrate).

2.   A magnetostatic circulator as set forth in Claim 1, wherein said chip is prepared by forming a yttrium iron garnet (YIG) epitaxial film on a gadolinium gallium garnet epitaxial substrate.

3. A magnetostatic circulator as set forth in Claim 2, further comprising: a package for holding said chip and said dielectric substrate; a plurality of coaxial connectors for connecting said conducting strips connected to said package with external conductors; and means for adjusting the position of said magnetic field generating means.

FIG. 1A

FIG. 1C

FIG. 1B

FIG. 1D

FIG. 2

# INTERNATIONAL SEARCH REPORT

0211958

International Application No. PCT/JP86/00040

## I. CLASSIFICATION OF SUBJECT MATTER (if several classification symbols apply, indicate all) [3]

According to International Patent Classification (IPC) or to both National Classification and IPC

Int.Cl$^4$      H01P1/38, 1/36, 1/32

## II. FIELDS SEARCHED

| Minimum Documentation Searched [4] | |
|---|---|
| Classification System | Classification Symbols |
| IPC | H01P1/38, 1/36, 1/32 |

| Documentation Searched other than Minimum Documentation to the Extent that such Documents are Included in the Fields Searched [5] | |
|---|---|
| Jitsuyo Shinan Koho | 1926 - 1985 |
| Kokai Jitsuyo Shinan Koho | 1971 - 1985 |

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| A | Television Gakkai-shi, Vol. 38, No. 12, (1984) Utsumi Yozo, Tsutsumi Makoto "Seijiha (MSW) Device no Doko", P.1053-1062 | 1, 2, 3 |

* Special categories of cited documents: [16]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| April 21, 1986 (21. 04. 86) | May 6, 1986 (06. 05. 86) |
| International Searching Authority [1] | Signature of Authorized Officer [20] |
| Japanese Patent Office | |

Form PCT/ISA/210 (second sheet) (October 1981)